# EUROPÄISCHE PATENTSCHRIFT

(11) **EP 3 417 272 B1**
(45) Veröffentlichungstag und Bekanntmachung des Hinweises auf die Patenterteilung: **10.07.2019**
(21) Anmeldenummer: 17712692.7
(22) Anmeldetag: 14.02.2017
(51) Int. Cl.: G01N 21/21, G01N 21/84, G11B 7/241, G11C 11/16, G11C 13/06, G01N 21/35, G01N 21/55, G01N 21/17

(54) **VERFAHREN ZUR BESTIMMUNG DES SPINZUSTANDS VON SPINÜBERGANGSVERBINDUNGEN, VERWENDUNG DES VERFAHRENS ZUM AUSLESEN VON DIGITALEN DATEN, UND OPTISCHES ODER MAGNETOPTISCHES SPEICHERMEDIUM**
METHOD FOR DETERMINING THE SPIN STATE OF SPIN TRANSITION COMPOUNDS, USE OF THE METHOD FOR READING DIGITAL DATA, AND OPTICAL OR MAGNETOPTICAL STORAGE MEDIUM
PROCEDE PERMETTANT DE DETERMINER L'ETAT DE SPIN DE COMPOSES DE TRANSITION DE SPIN, UTILISATION DU PROCEDE DE LECTURE DE DONNEES NUMERIQUES, ET SUPPORT DE STOCKAGE OPTIQUE OU MAGNETOPTIQUE

(30) Priorität: 15.02.2016 AT 772016
(43) Veröffentlichungstag der Anmeldung: 26.12.2018
(73) Patentinhaber: Technische Universität Wien, 1040 Wien (AT)
(72) Erfinder: MÜLLER, Danny, 1080 Wien (AT); WEINBERGER, Peter, 3422 Altenberg (AT)
(74) Vertreter: Ellmeyer, Wolfgang
(86) Internationale Anmeldenummer: PCT/AT2017/060028
(87) Internationale Veröffentlichungsnummer: WO 2017/139820

(56) Entgegenhaltungen:
- JP-A- 2015 072 427
- DATABASE WPI Week 201531 Thomson Scientific, London, GB; AN 2015-24432E XP002770088, & JP 2015 072427 A (UNIV TOKYO) 16. April 2015 (2015-04-16)
- OREN BEN DOR ET AL: "A chiral-based magnetic memory device without a permanent magnet", NATURE COMMUNICATIONS, Bd. 4, 6. August 2013 (2013-08-06), XP055214664, DOI: 10.1038/ncomms3256

## Beschreibung

Die vorliegende Erfindung betrifft ein Verfahren zur Bestimmung des Spinzustands von Spinübergangsverbindungen, eine Verwendung eines solchen Verfahrens zum Auslesen von digitalen Daten, und ein optisches oder magnetooptisches Speichermedium.

### STAND DER TECHNIK

Bei dem bereits 1931 von den italienischen Forschern Cambi und Szegö entdeckten Spin-Übergangseffekt handelt es sich um den Wechsel einiger Übergangsmetalle mit der Elektronenkonfiguration d⁴ bis d⁷ zwischen einem Low-Spin- (LS-) und einem High-Spin- (HS-) Zustand, die sich in der Anzahl der ungepaarten Elektronen unterscheiden. Als Folge des Spinübergangs ändern sich bestimmte Eigenschaften der Materialien, vor allem das magnetische Verhalten (z.B. zwischen dia- und paramagnetisch), aber auch die Struktur (Bindungslängen), elektrische (Dielektrizitätskonstante) und optische Eigenschaften (Farbe, Brechungsindex) entsprechender Komplexverbindungen.

Der Wechsel zwischen den beiden Spinzuständen lässt sich durch Zufuhr von Energie wie etwa Wärme, Druck oder auch durch Bestrahlung mit Licht definierter Wellenlänge, z.B. mittels Laser, induzieren. Der mittels Licht angeregte Übergang vom LS- in den HS-Zustand wird als LIESST-Effekt ("light induced excited spin state trapping") bezeichnet.

Aufgrund der äußerst rasch vonstatten gehenden Übergänge im Bereich von Femtosekunden richten sich jüngste Forschungen vor allem auf etwaige Anwendungen solcher Komplexverbindungen im Bereich der Sensorik, Magnetooptik, Datenspeicherung und Miniaturisierung schaltbarer Bauelemente. Ein bislang noch nicht zufrieden stellend gelöstes Hauptproblem im Hinblick auf eine technologische Anwendung ist dabei die Detektion des jeweils vorliegenden Spinzustands der Verbindungen, die nicht nur einfach durchführbar sein, sondern vor allem auch zerstörungsfrei erfolgen muss, ohne den Spinzustand durch dessen Bestimmung zu verändern. Zerstörungsfreie Detektionsmethoden, wie z.B. diverse Spektroskopieverfahren (IR-, UV-VIS/NIR-, Raman- oder Mößbauer-Spektroskopie), Strukturaufklärung oder Bestimmungen des magnetischen Moments, sind allerdings mit einem hohen apparativen Aufwand verbunden und für Miniaturisierung und kommerzielle Anwendung daher de facto ungeeignet.

Speziell für den Zweck der Nutzung des LIESST-Effekts zur Konstruktion von magnetooptischen Bauelementen wäre es wünschenswert, monomolekulare Schichten, d.h. Monolagen oder Monolayers, einer beliebigen Spinübergangsverbindung auf einer geeigneten Oberfläche zu immobilisieren, was bislang ebenfalls noch nicht gelungen ist. Bei diversen Versuchen, Spinübergangsverbindungen auf (Metall-)Oberflächen abzuscheiden, z.B. mittels Vakuum-Abscheidung, Langmuir-Blodgett-Technik etc., wurden entweder mehr oder weniger dicke Filme und somit Multilayers, also Mehrfachlagen der jeweiligen Spinübergangsverbindung (siehe z.B. Ludwig et al., Angew. Chem. Int. Edit. 53(11), 3019-3023 (2014); Naggert et al., J. Mater. Chem. C 3(30), 7870-7877 (2015); Cobo et al., Angew. Chem. Int. Edit. 45(35), 5786-5789 (2006)), oder aber Submonolayers, d.h. eine unvollständige Bedeckung des Trägers mit der Verbindung erzeugt (Bernien et al., J. Phys. Chem. Lett. 3(23), 3431-3434 (2012)).

Im Falle von Cobo et al. (s.o.) wurden zudem nicht nur Mehrfachlagen, konkret Multilayers bimetallischer Komplexverbindungen vom Hofmann-Typ, sondern sogar ein dreidimensionales Netzwerk dieser Verbindungen erzeugt, in dem in mehreren vertikalen Schichten von Eisen-Pyrazin-Komplexen das Fe²⁺-Ion jeweils über negativ geladene Cyanidkomplexe eines zweiten Metallions, M(CN)₄²⁻ (mit M = Ni, Pd, Pt), miteinander verbunden sind. Durch eine solche Vernetzung in horizontaler Richtung würde sich allerdings jedwede zur Veränderung des Spinzustands in vertikaler Richtung zugeführte Energie auch horizontal ausbreiten, was eine gezielte, lokal begrenzte Anregung einzelner Spinübergangskomplexe gänzlich unmöglich macht.

Erst in jüngster Zeit wurden die optischen Eigenschaften chiraler Spinübergangsverbindungen untersucht, da eine Änderung deren Spinzustands auch die chirooptischen Eigenschaften ändern sollte, die mit dem elektronischen Zustand der jeweiligen Komplexverbindung verknüpft sind. So offenbaren Guralskiy et al. in J. Mater. Chem. C 3, 4737 (2015) ("Guralskiy et al. 1") die Änderung der optischen Eigenschaften des Komplexes [Fe(NH₂trz)₃](L-CSA)₂, bestehend aus einem von 4-Amino-1,2,4-triazol (NH₂trz) und Fe²⁺-Ionen gebildeten, kettenförmigen Polykation [Fe(NH₂trz)₃]²⁺ und dem chiralen L-Camphersulfonat-Anion. Dabei wurden Nanopartikel aus Poly[tris-(4-amino-1,2,4-tri-azolato)eisen(II)-camphersulfonat] als stabiles Kolloid in Acetonitril gebildet, wobei die achiralen kationischen Ketten durch das chirale Anion neutralisiert werden und dadurch ein chirales Netzwerk erhalten wird. In der Folge wurde der Spinübergang zum HS-Zustand thermisch angeregt. Mittels UV-VIS-Spektroskopie wurde festgestellt, dass sich durch den Spinübergang der Circulardichroismus des polymeren Komplexes änderte.

Wenig später publizierten Guralskiy et al. in Chem. Eur. J. 21, 18076-18079 (2015) ("Guralskiy et al. 2") Ergebnisse von Experimenten mit demselben polymeren Komplex, diesmal mit (S)- und (R)-2-Butanol als Solvat. Bei Aufnahme der beiden unterschiedlichen Enantiomere in die Polymerkette wurde mittels magnetischer Messungen eine somit enantioselektive Verschiebung der Spinübergangs-Temperatur von 2 K festgestellt, was durch die unterschiedliche Konfiguration der eingelagerten Alkohole in die durch die chiralen Camphersulfonate gebildeten und somit vorgegebenen Lücken erklärt wird. Auswirkungen auf chirooptische Eigenschaften wurden allerdings nicht berichtet.

Qin et al. (CrystEngComm 17, 7956-7963 (2015)) offenbaren zudem die Möglichkeit, unter Verwendung eines mit Acetonitril solvatisierten Spinübergangskomplexes zwischen verschiedenen chiralen Nitrilen (Lactonitril und Methylglutaronitril) zu unterscheiden. Durch Austausch eines Teils der Acetonitril-Moleküle in den Solvaten durch ein chirales Nitril kommt es bei anschließender Co-Kristallisation zu einer Änderung der Helixform der Kristalle des Komplexes, was eine Änderung der Temperatur des thermischen Spinübergangs nach sich zieht. Änderungen der chirooptischen Eigenschaften des Spinübergangskomplexes selbst - ohne solvatisierendes Nitril - werden darin allerdings nicht näher untersucht.

Auch die in diesen jüngsten, sich mit chiralen Spinübergangskomplexen befassenden Publikationen offenbarten Methodiken und die darin enthaltenen Ausblicke auf etwaige zukünftige Anwendungen lösen allerdings die obigen Probleme nicht: Messungen des Circulardichroismus von chiralen Verbindungen sind aufgrund des Transmissionssetups kaum in miniaturisierter Form durchführbar. Um aus den relativ geringen Unterschieden in der Absorption von in gegensätzlichen Drehrichtungen zirkular polarisiertem Licht nach Passage einer chiralen Spinübergangsverbindung zuverlässig deren Spinzustand ableiten zu können, muss das Licht durch chirale Matrices ausreichender Dicke geleitet werden, um überhaupt signifikante Differenzen messen zu können. Abgesehen davon sind Messungen des Cirulardichroismus lediglich für die Flüssigphase geeignet. Eine Anwendbarkeit für Monolagen von Spinübergangsverbindungen ist dadurch praktisch ausgeschlossen.

Zu all dem kommt, dass ein zu geringer Abstand der Spinübergangsverbindungen von der damit beschichteten Metalloberfläche reproduzierbare Übergänge zwischen den Spinzuständen verhindert (siehe z.B. Bernien et al. (s.o.); Miyamachi et al., Nat. Commun. 3, 938 (2012)), was ein weiteres bislang ungelöstes Problem darstellt.

JP 2015 072427 A offenbart ein Verfahren zum Bestimmen des Spinzustands einer Spinübergangsverbindung (eine chirale, helikale Kristallstruktur eines achiralen Liganden 4-Brompyridin) gemäß des Oberbegriffs des Anspruchs 1.

Ziel der Erfindung war vor diesem Hintergrund die Bereitstellung eines Verfahrens, durch das die obigen Nachteile des Standes der Technik zumindest teilweise ausgemerzt werden können.

### OFFENBARUNG DER ERFINDUNG

Dieses Ziel erreicht die vorliegende Erfindung in einem ersten Aspekt durch Bereitstellung eines Verfahrens zum Bestimmen des Spinzustands einer Spinübergangsverbindung mittels Bestrahlung mit Licht in einem definierten Wellenlängenbereich, um eine Wechselwirkung des Lichts mit der Spinübergangsverbindung zu bewirken, Detektion von durch diese Wechselwirkung verursachten Änderungen der Eigenschaften des Lichts und Korrelation dieser Änderungen mit dem Spinzustand der Verbindung, wobei eine Spinübergangsverbindung mit in Abhängigkeit vom Spinzustand veränderlichen chirooptischen Eigenschaften eingesetzt wird, die Bestrahlung mit polarisiertem Licht erfolgt und die Änderung der Eigenschaften des Lichts mit den chirooptischen Eigenschaften der Verbindung korreliert werden, wobei die Bestrahlung mit linear polarisiertem Licht erfolgt; und eine Änderung der Polarisationsrichtung des Lichts detektiert und diese mit dem Spinzustand der Verbindung in Korrelation gesetzt wird, mit dem Kennzeichen, dass
a) als Spinübergangsverbindung ein chiraler Übergangsmetallkomplex mit zumindest einem chiralen Liganden eingesetzt wird; und
b) die Spinübergangsverbindung in fester Form an eine feste Oberfläche gebunden vorliegt.

Im erfindungsgemäßen Verfahren werden somit Änderungen der Polarisationsrichtung detektiert, die auf einem direkten Einfluss des Spinübergangszentrums auf die chirooptischen Eigenschaften der umgebenden chiralen, vorzugsweise natürlich enantiomerenreinen chiralen, Liganden beruhen uns daher direkt durch das Spinübergangszentrum und nicht durch Sekundäreffekte, wie z.B. Volumenskontraktion, ausgelöst werden, wie dies etwa auf die in "Guralskiy et al. 1" detektierten Änderungen des Circulardichroismus von chiralen Anionen umfassenden Komplexen zutrifft.

Zudem beruhen solche Änderungen des Circulardichroismus auf Absorptionseffekten, während sich gemäß vorliegender Erfindung durch den Spinübergang der Drehwinkel des linear polarisierten Lichts ändert. Aufgrund der niedrigeren Nachweisgrenzen bei Messungen des Drehwinkels, z.B. mittels Polarimeter, sind deutlich dünnere Schichten der Spinübergangsverbindungen auf einer Oberfläche möglich als zur zuverlässigen Bestimmung von Änderungen des Circulardichroismus. Vor allem aber ist es gemäß vorliegender Erfindung nicht erforderlich, zwei gegenläufig zirkular polarisierte Lichtstrahlen auszusenden, was den Messvorgang erheblich beschleunigt, beispielsweise wenn auf einem Datenträger gespeicherte Informationen ausgelesen werden sollen, worauf später noch näher eingegangen wird .

Als linear polarisiertes Licht wird dabei vorzugsweise solches mit einer Wellenlänge im Bereich von Ultraviolett- bis Infrarotstrahlung eingesetzt, wobei für den Fall, dass die Spinübergänge durch Bestrahlung ausgelöst werden, für eine ausreichende Differenz zu jenen Wellenlängen gesorgt werden muss, bei denen die Spinübergänge induziert werden.

Die Spinübergangsverbindung kann dabei in beliebiger fester Form, beispielsweise amorph, kristallin oder teilkristallin, vorliegen, was dünne Schichten erlaubt.

Gemäß des erfindungsgemäßen Verfahrens liegt die Spinübergangsverbindung in fester Form an eine feste Oberfläche gebunden vor, besonders bevorzugt in einer geringen Anzahl an Mehrfachlagen oder auch als Monolage, abhängig vom spezifischen Drehwinkel der jeweiligen Spinübergangsverbindung.

Eine solche Monolage der Spinübergangsverbindung ist vorzugsweise an eine reflektierende feste Oberfläche gebunden, wie dies etwa bei der Auslesung von auf festen Datenträgern gespeicherten Informationen der Fall ist, um Änderungen der Polarisationsebene des von der festen Oberfläche reflektierten Lichts detektieren zu können. Die feste Oberfläche mit der daran gebundenen Spinübergangsverbindung ist dabei vorzugsweise Teil eines optischen oder magnetooptischen Speichermediums.

Die jeweilige Spinübergangsverbindung ist nicht speziell eingeschränkt, solange sie optisch aktiv, d.h. Chiralität zeigt. Vorzugsweise wird als chiraler Übergangsmetallkomplex ein chiraler Komplex mit einem Übergangsmetall der Elektronenkonfiguration d⁴ bis d⁷, vorzugsweise mit einem Eisenion, noch bevorzugter mit Fe²⁺, als Zentralatom eingesetzt, da solche Komplexe einfach und kostengünstig herstellbar und gut erforscht sind.

Das Chiralitätszentrum kann dabei sowohl in den das Zentralatom koordinierenden Liganden, d.h. in komplexen Kationen, als auch in zugehörigen Anionen sitzen. Vorzugsweise befindet es sich allerdings in zumindest einem Liganden in unmittelbarer Umgebung des Zentralatoms, da dies die Wechselwirkung mit dem Kation des Übergangsmetalls fördert und Änderungen des Spinzustands desselben stärkere Auswirkungen auf die chirooptischen Eigenschaften des Komplexes zeigen. Erfindungsgemäß wird daher ein chiraler Übergangsmetallkomplex mit zumindest einem, besonders bevorzugt aber ausschließlich chiralen Liganden eingesetzt. Chirale Komplexe mit ausschließlich chiralen Liganden und insbesondere solche, die zusätzlich noch ein chirales Anion aufweisen, können selbst in dünnsten Schichten noch detektierbare Änderungen der Polarisationsrichtung des Lichts erzeugen, insbesondere auch als Monolage.

Vorzugsweise wird ein chiraler Komplex eines Übergangsmetalls mit aus gegebenenfalls substituierten Heterozyklen, vorzugsweise substituierten Stickstoff-Heterozyklen wie Pyrrolidin, Pyrrol, Piperidin, Pyridin, Pyrazol, Imidazol, Pyrimidin, Triazol und Tetrazol, ausgewählten Liganden eingesetzt, da solche Liganden hohe Koordinationsfähigkeit besitzen, in einfacher Weise derivatisierbar sind und zum Teil ebenfalls relativ gut erforschte Eigenschaften aufweisen, wie dies speziell für chirale Imidazol-, Triazol- und Tetrazol-Verbindungen als Liganden gilt. In besonders bevorzugten Ausführungsformen der Erfindung wird ein chiraler Übergangsmetallkomplex mit Fe²⁺ als Zentralatom und substituierten Tetrazolen als chiralen Liganden eingesetzt.

In einem zweiten Aspekt stellt die vorliegende Erfindung die Anwendung eines Verfahrens gemäß dem obigen ersten Aspekt zum Auslesen von digitalen Daten bereit, die auf einem optischen oder magnetooptischen Speichermedium gespeichert sind, das auf zumindest einer Oberfläche eine Beschichtung mit einem chiralen Übergangsmetallkomplex mit zumindest einem chiralen Liganden aufweist, dessen Spinzustand durch Bestrahlung mit Licht definierter Wellenlänge veränderbar ist. Zwar ist auch thermische Induktion der Spinzustandsänderungen möglich, aber aufgrund der längeren Reaktionszeiten erfindungsgemäß nicht bevorzugt.

In einem dritten Aspekt stellt die Erfindung ein optisches oder magnetooptisches Speichermedium bereit, das zumindest eine Oberfläche aufweist, die mit einem zuvor definierten chiralen Übergangsmetallkomplex mit zumindest einem chiralen Liganden, insbesondere mit einer Monolage eines solchen chiralen Übergangsmetallkomplexes, beschichtet ist.

### KURZBESCHREIBUNG DER ZEICHNUNGEN

Die vorliegende Erfindung wird nachstehend anhand eines konkreten Beispiels und unter Bezugnahme auf die beiliegenden Zeichnungen näher beschrieben, die Folgendes zeigen:
Fig. 1 unpolarisierte Spektren der in Beispiel 1 eingesetzten Spinübergangsverbindung im LS- (unten) und HS- (oben) Zustand; und
die Fig. 2 und 3 polarisierte Spektren der in Beispiel 1 eingesetzten Spinübergangsverbindung im LS- (unten) und HS- (oben) Zustand.

### BEISPIELE

### Beispiel 1

Ein Einkristall der chiralen Spinübergangsverbindung [Fe((S)-1-(1H-Tetrazol-1-yl)propan-2-ol)](ClO₄)₂·H₂O wurde in den Strahlengang eines mit zwei Polarisatoren ausgestatteten IR-Spektrometers eingebracht. Der Spinübergang dieser Verbindung vom LS- zum HS-Zustand wurde bei -70 °C thermisch angeregt. Während dieser Anregung wurden sowohl unpolarisierte und polarisierte IR-Messungen durchgeführt.

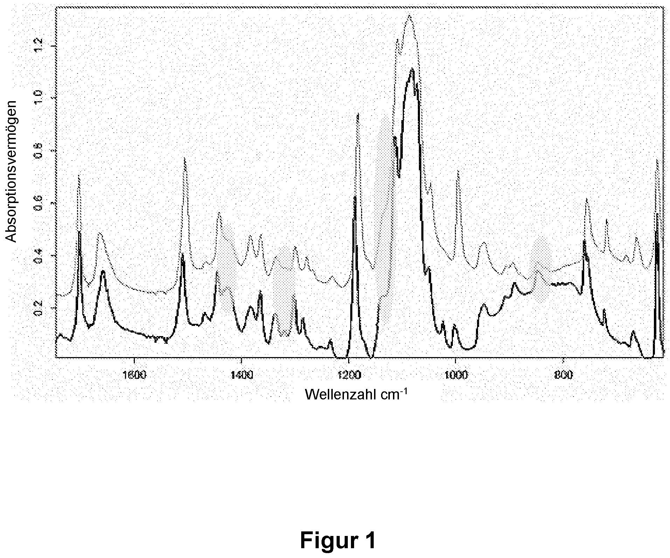

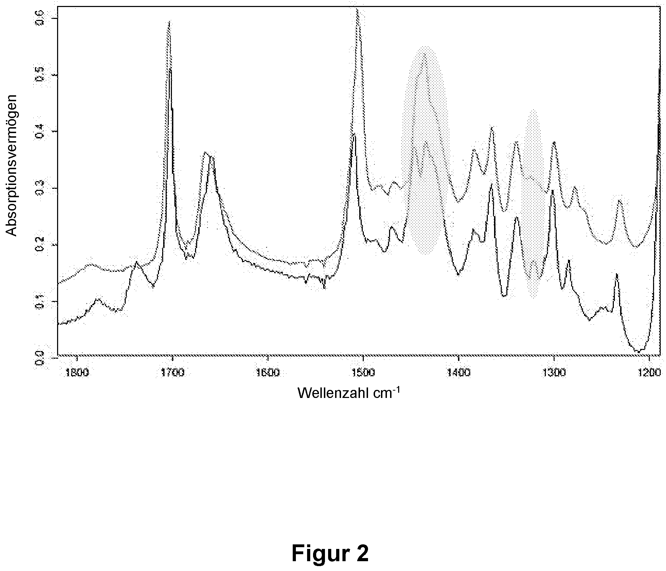

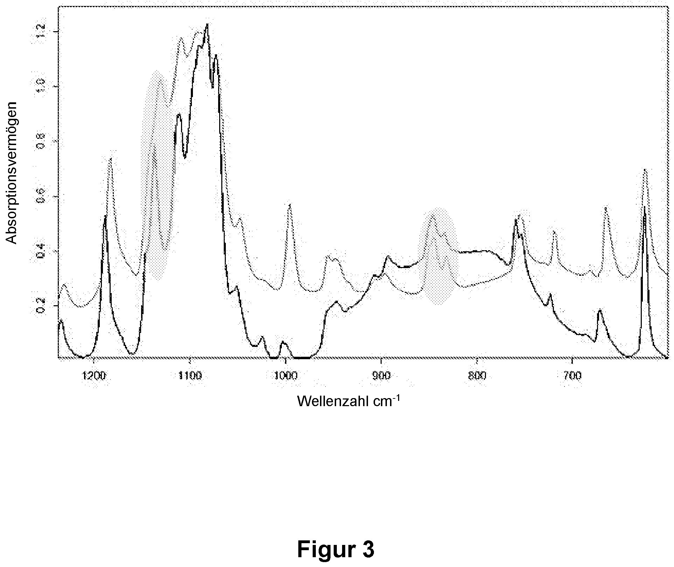

Die in Fig. 1 gezeigten unpolarisierten Spektren über den Wellenzahlbereich von 1800 bis 600 cm⁻¹ zeigen keine signifikante Veränderung der Spinübergangsverbindung beim Übergang vom HS-Zustand (grau, oben) zum LS-Zustand (schwarz, unten). Bei polarisierten Messungen traten hingegen signifikante Änderungen in den Spektren sowie der Polarisation zutage, wie dies in den Fig. 2 und 3 dargestellt ist, die die polarisierten Spektren der Spinübergangsverbindung, wiederum im HS-Zustand (grau, oben) und im LS-Zustand (schwarz, unten) über den Wellenzahlbereich von 1800 bis 600 cm⁻¹ zeigen. Die Unterschiede in den Intensitäten der grau unterlegten Banden in den polarisierten Spektren bei 1442 cm⁻¹, 1340 cm⁻¹, 1140 cm⁻¹ und 843 cm⁻¹ lassen - je nach Spinzustand - eine eineindeutige Zuordnung des Spinzustands zur polarisierten spektralen Information zu. Das die unpolarisierten Spektren diese vom Spinzustand abhängige Veränderung nicht zeigen, bedeutet, dass der Spinzustand unter Verwendung von polarisiertem Licht eindeutig feststellbar ist. Die Banden bei den oben angebenenen Wellenzahlen entsprechen Molekülschwingungen, die vom Fe-Zentrum unabhängig sind und lediglich den Liganden, insbesondere das asymmetrische C-Atom, inkludieren. Dies erklärt, warum die Schwingungen im unpolarisierten Spektrum keine Spinzustandabhängigkeit aufweisen. Dies belegt ebenfalls, dass die elektronischen und geometrischen Änderungen, die das Fe-Atom durch den Spinübergang und somit eineindeutig für beide Spinzustände aufweist, einen markanten Einfluss auf die chirooptischen Eigenschaften der chiralen enantiomerenreinen Liganden besitzen. Der Zusammenhang zwischen der spektralen Änderung und der chiralen Information im Liganden wurde über quantenchemische Rechnungen bestätigt.

Diese spektroskopisch aufgelösten Änderungen der einzelnen Banden im polarisierten Spektrum bedingen eine Änderung der Gesamtpolarisation und somit eine Drehung der Polarisationsebene von den Spinübergangskomplex passierendem, linear polarisiertem Licht, die für eine technologische Anwendung unter vereinfachter Detektion herangezogen werden kann. Dies zeigt sich durch eine Aufhebung der Totalauslöschung, wenn ein Kristall der oben angeführten Verbindung im HS-Zustand zwischen zwei gekreuzte Polarisatoren eingebracht wird. Wird nun mit dem Kristall zwischen Polarisator und Analysator durch Neujustierung die Totalauslöschung wiederum hervorgerufen und der Spinzustand durch Änderung der Temperatur gewechselt (HS → LS), wird die Totalauslöschung abermals aufgehoben.

### Beispiel 2

Ein Einkristall der chiralen Spinübergangsverbindung [Fe((R)-1-(1H-Tetrazol-1-yl)propan-2-ol)](ClO₄)₂·H₂O, d.h. des zum (S)-Enantiomer aus Beispiel 1 "spiegelbildlichen" (R)-Enantiomers, wurde in den Strahlengang eines mit zwei Polarisatoren ausgestatteten IR-Spektrometers eingebracht. Der Spinübergang dieser Verbindung vom LS-zum HS-Zustand wurde ebenfalls bei -70 °C thermisch angeregt. Während dieser Anregung wurden erneut sowohl unpolarisierte und polarisierte IR-Messungen durchgeführt

Die Spektren und experimentellen Befunde entsprechen vollkommen den in Beispiel 1 für das (S)-Enantiomer angeführten, was belegt, dass auch dieses reine Enantiomer für die Verwendung im erfindungsgemäßen Verfahren bestens geeignet ist.

## Patentansprüche

1. Verfahren zum Bestimmen des Spinzustands einer Spinübergangsverbindung mittels Bestrahlung mit Licht in einem definierten Wellenlängenbereich, um eine Wechselwirkung des Lichts mit der Spinübergangsverbindung zu bewirken, Detektion von durch diese Wechselwirkung verursachten Änderungen der Eigenschaften des Lichts und Korrelation dieser Änderungen mit dem Spinzustand der Verbindung, wobei eine Spinübergangsverbindung mit in Abhängigkeit vom Spinzustand veränderlichen chirooptischen Eigenschaften eingesetzt wird, die Bestrahlung mit polarisiertem Licht erfolgt und die Änderung der Eigenschaften des Lichts mit den chirooptischen Eigenschaften der Verbindung korreliert werden, wobei die Bestrahlung mit linear polarisiertem Licht erfolgt und eine Änderung der Polarisationsrichtung des Lichts detektiert und diese mit dem Spinzustand der Verbindung in Korrelation gesetzt wird,
**dadurch gekennzeichnet, dass**
a) als Spinübergangsverbindung ein chiraler Übergangsmetallkomplex mit zumindest einem chiralen Liganden eingesetzt wird; und
b) die Spinübergangsverbindung in fester Form an eine feste Oberfläche gebunden vorliegt.

2. Verfahren nach Anspruch 1, **dadurch gekennzeichnet, dass** linear polarisiertes Licht mit einer Wellenlänge im Bereich von Ultraviolett- bis Infrarotstrahlung eingesetzt wird.

3. Verfahren nach Anspruch 1 oder 2, **dadurch gekennzeichnet, dass** eine Monolage der Spinübergangsverbindung an eine reflektierende feste Oberfläche gebunden ist.

4. Verfahren nach Anspruch 3, **dadurch gekennzeichnet, dass** Änderungen der Polarisationsrichtung des von der festen Oberfläche reflektierten Lichts detektiert werden.

5. Verfahren nach Anspruch 3 oder 4, **dadurch gekennzeichnet, dass** die feste Oberfläche mit der daran gebundenen Spinübergangsverbindung Teil eines optischen oder magnetooptischen Speichermediums ist.

6. Verfahren nach einem der Ansprüche 1 bis 5, **dadurch gekennzeichnet, dass** als chiraler Übergangsmetallkomplex ein chiraler Komplex mit einem Übergangsmetall der Elektronenkonfiguration d⁴ bis d⁷, vorzugsweise mit einem Eisenion, noch bevorzugter mit Fe²⁺, als Zentralatom eingesetzt wird.

7. Verfahren nach einem der Ansprüche 1 bis 6, **dadurch gekennzeichnet, dass** ein chiraler Übergangsmetallkomplex mit durchwegs chiralen Liganden eingesetzt wird.

8. Verfahren nach einem der Ansprüche 1 bis 7, **dadurch gekennzeichnet, dass** ein chiraler Übergangsmetallkomplex mit zumindest einem chiralen Liganden und zusätzlich mit einem chiralen Anion eingesetzt wird.

9. Verfahren nach einem der Ansprüche 1 bis 8, **dadurch gekennzeichnet, dass** ein chiraler Komplex eines Übergangsmetalls mit aus gegebenenfalls substituierten Heterozyklen, vorzugsweise substituierten Stickstoff-Heterozyklen wie Pyrrolidin, Pyrrol, Piperidin, Pyridin, Pyrazol, Imidazol, Pyrimidin, Triazol und Tetrazol, ausgewählten Liganden eingesetzt wird.

10. Verfahren nach Anspruch 9, **dadurch gekennzeichnet, dass** ein chiraler Übergangsmetallkomplex mit chiralen Imidazol-, Triazol- oder Tetrazol-Verbindungen als Liganden eingesetzt wird.

11. Verfahren nach einem der Ansprüche 6 bis 10, **dadurch gekennzeichnet, dass** ein chiraler Übergangsmetallkomplex mit Fe²⁺ als Zentralatom und substituierten Tetrazolen als chiralen Liganden eingesetzt wird.

12. Verwendung eines Verfahrens nach einem der Ansprüche 1 bis 11 zum Auslesen von digitalen Daten, die auf einem optischen oder magnetooptischen Speichermedium gespeichert sind, das auf zumindest einer Oberfläche eine Beschichtung mit einem chiralen Übergangsmetallkomplex mit zumindest einem chiralen Liganden aufweist, dessen Spinzustand durch Bestrahlung mit Licht definierter Wellenlänge veränderbar ist.

13. Optisches oder magnetooptisches Speichermedium, umfassend zumindest eine Oberfläche, die mit einem chiralen Übergangsmetallkomplex mit zumindest einem chiralen Liganden, wie in einem der Ansprüche 1 bis 11 definiert, beschichtet ist.

14. Speichermedium nach Anspruch 13, **dadurch gekennzeichnet, dass** die zumindest eine Oberfläche mit einer Monolage des chiralen Übergangsmetallkomplexes beschichtet ist.

## Claims

1. A process for determining the spin state of a spin transition compound by irradiating it with light having a wavelength in a defined wavelength range in order to effectuate an interaction between said spin transition compound and said light, detecting changes in the light's properties caused by said interaction and correlating these changes with the spin state of said compound, wherein a spin transition compound having chiro-optical properties that change depending on the compound's spin state is used, polarized light is used for irradiating said compound and a change in the light's properties is correlated with the chiro-optical properties of said compound, wherein linearly polarized light is used for irradiating said compound and a change of the light's polarization direction is detected and correlated with the spin state of said compound, **characterized in that**
a) a chiral transition metal complex comprising at least one chiral ligand is used as said spin transition compound; and
b) said spin transition compound is present in its solid state and bound to a solid surface.

2. The process according to claim 1, **characterized in that** linearly polarized light having a wavelength ranging from ultraviolet to infrared radiation is used.

3. The process according to claim 1 or claim 2, **characterized in that** a monolayer of said spin transition compound is bound to a reflective solid surface.

4. The process according to claim 3, **characterized in that** changes in the polarization direction of the light that is reflected by the solid surface are detected.

5. The process according to claim 3 or claim 4, **characterized in that** the solid surface and the spin transition compound bound to it are part of an optical or magneto-optical storage medium.

6. The process according to any one of the claims 1 to 5, **characterized in that** a chiral complex comprising a transition metal having an electron configuration d⁴ to d⁷, preferably an iron ion, more preferably Fe²⁺, as its central atom is used as said chiral transition metal complex.

7. The process according to any one of the claims 1 to 6, **characterized in that** a chiral transition metal complex comprising only chiral ligands is used.

8. The process according to any one of the claims 1 to 7, **characterized in that** a chiral transition metal complex comprising at least one chiral ligand and, additionally, a chiral anion is used.

9. The process according to any one of the claims 1 to 8, **characterized in that** a chiral transition metal complex comprising ligands selected from optionally substituted heterocycles, preferably from substituted nitrogen heterocycles such as pyrrolidine, pyrrole, piperidine, pyridine, pyrazole, imidazole, pyrimidine, triazole and tetrazole, is used.

10. The process according to claim 9, **characterized in that** a chiral transition metal complex comprising chiral imidazole, triazole or tetrazole compounds as ligands is used.

11. The process according to any one of the claims 6 to 10, **characterized in that** a chiral transition metal complex comprising Fe²⁺ as its central atom and substituted tetrazoles as chiral ligands is used.

12. A use of a process according to any one of the claims 1 to 11 for reading out digital data being stored on an optical or magneto-optical storage medium having, on at least one surface thereof, a coating which consists of a chiral transition metal complex comprising at least one chiral ligand, the spin state of said complex being changeable by irradiating it with light having a defined wavelength.

13. An optical or magneto-optical storage medium comprising at least one surface that is coated with a chiral transition metal complex comprising at least one chiral ligand, as defined in any one of the claims 1 to 11.

14. The storage medium according to claim 13, **characterized in that** said at least one surface is coated with a monolayer of said chiral transition metal complex.

## Revendications

1. Procédé pour déterminer l'état de spin d'un composé à transition de spin par irradiation avec de la lumière d'une longueur d'ondes comprise dans une plage prédéfinie de longueurs d'ondes pour provoquer une interaction entre la lumière et le composé à transition de spin, détection de changements des caractéristiques de la lumière causés pas cette interaction et corrélation de ces changements avec l'état de spin du composé, dans lequel est employé un composé à transition de spin ayant des caractéristiques chiro-optiques modifiables en fonction de l'état de spin, l'irradiation est effectuée avec de la lumière polarisée et le changement des caractéristiques de la lumière est corrélé avec les caractéristiques chiro-optiques du composé, dans lequel l'irradiation est effectuée avec de la lumière polarisée de manière linéaire, et un changement de la direction de polarisation de la lumière est détecté et mis en corrélation avec l'état de spin du composé, **caractérisé en ce que**
a) un complexe chiral de métal de transition comprenant au moins un ligand chiral est employé comme composé à transition de spin; et
b) le composé à transition de spin est présent à l'état solide et lié à une surface solide.

2. Procédé selon la revendication 1, **caractérisé en ce que** de la lumière polarisée de manière linéaire ayant une longueur d'ondes comprise entre le rayonnement ultraviolet et le rayonnement infrarouge est employée.

3. Procédé selon les revendications 1 ou 2, **caractérisé en ce qu'**une monocouche du composé à transition de spin est liée à une surface solide réfléchissante.

4. Procédé selon la revendication 3, **caractérisé en ce que** des changements de la direction de polarisation de la lumière réfléchie par la surface solide sont détectés.

5. Procédé selon les revendications 3 ou 4, **caractérisé en ce que** la surface solide et le composé à transition de spin lié à celle-ci font partie d'un support de données optique ou magnéto-optique.

6. Procédé selon l'une quelconque des revendications 1 à 5, **caractérisé en ce qu'**un complexe chiral comprenant un métal de transition d'une configuration électronique d⁴ à d⁷, préférentiellement un ion fer, plus préférentiellement du Fe²⁺, comme atome central est employé comme complexe chiral de métal de transition.

7. Procédé selon l'une quelconque des revendications 1 à 6, **caractérisé en ce qu'**un complexe chiral de métal de transition comprenant uniquement des ligands chiraux est employé.

8. Procédé selon l'une quelconque des revendications 1 à 7, **caractérisé en ce qu'**un complexe chiral de métal de transition comprenant au moins un ligand chiral et en plus un anion chiral est employé.

9. Procédé selon l'une quelconque des revendications 1 à 8, **caractérisé en ce qu'**un complexe chiral d'un métal de transition comprenant des ligands choisis parmi des hétérocycles éventuellement substitués, préférentiellement des hétérocycles azotés substitués, telles que la pyrrolidine, la pyrrole, la pipéridine, la pyridine, la pyrazole, l'imidazole, la pyrimidine, la triazole et la tétrazole, est employé.

10. Procédé selon la revendication 9, **caractérisé en ce qu'**un complexe chiral de métal de transition comprenant des composés chiraux d'imidazole, triazole ou tétrazole comme ligands est employé.

11. Procédé selon l'une quelconque des revendications 6 à 10, **caractérisé en ce qu'**un complexe chiral de métal de transition ayant Fe²⁺ comme atome central et des tétrazoles substituées comme ligands chiraux est employé.

12. Utilisation d'un procédé selon l'une quelconque des revendications 1 à 11 pour extraire des données numériques enregistrées sur un support de données optique ou magnéto-optique ayant, sur au moins une surface, un revêtement avec un complexe chiral de métal de transition comprenant au moins un ligand chiral, dont l'état de spin est modifiable par irradiation avec une lumière d'une longueur d'ondes prédéfinie.

13. Support de données optique ou magnéto-optique, comprenant au moins une surface revêtue d'un complexe chiral de métal de transition comprenant au moins un ligand chiral selon la définition d'une quelconque des revendications 1 à 11.

14. Support de données selon la revendication 13, **caractérisé en ce que** l'au moins une surface est revêtue d'une monocouche du complexe chiral de métal de transition.
